(19) Europäisches Patentamt
European Patent Office
Office européen des brevets

(11) **EP 4 142 456 B1**

(12) **EUROPEAN PATENT SPECIFICATION**

(45) Date of publication and mention
of the grant of the patent:
**02.10.2024  Bulletin 2024/40**

(21) Application number: **22189585.7**

(22) Date of filing: **09.08.2022**

(51) International Patent Classification (IPC):
**H10N 30/87** *(2023.01)*       **H10N 30/853** *(2023.01)*

(52) Cooperative Patent Classification (CPC):
**H10N 30/877; H10N 30/704;** H10N 30/708;
H10N 30/8554

(54) **PIEZOELECTRIC LAMINATE AND PIEZOELECTRIC ELEMENT**

PIEZOELEKTRISCHES LAMINAT UND PIEZOELEKTRISCHES ELEMENT

STRATIFIÉ PIÉZOÉLECTRIQUE ET ÉLÉMENT PIÉZOÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.08.2021   JP 2021141804**

(43) Date of publication of application:
**01.03.2023   Bulletin 2023/09**

(73) Proprietor: **FUJIFILM Corporation
Tokyo 106-8620 (JP)**

(72) Inventors:
  • **MOCHIZUKI, Fumihiko
    Kaisei-machi, Ashigarakami-gun, Kanagawa
    258-8577 (JP)**
  • **SASAKI, Tsutomu
    Kaisei-machi, Ashigarakami-gun, Kanagawa
    258-8577, 258-8577 (JP)**

(74) Representative: **HGF
    HGF Limited
    1 City Walk
    Leeds LS11 9DX (GB)**

(56) References cited:
**EP-A2- 1 677 368         JP-A- 2000 015 809
US-A1- 2011 109 701**

**Description**

**BACKGROUND OF THE INVENTION**

1. Field of the Invention

The present disclosure relates to a piezoelectric laminate and a piezoelectric element.

2. Description of the Related Art

As a material having excellent piezoelectric characteristics and excellent ferroelectricity, there is known a perovskite-type oxide such as lead zirconate titanate ($Pb(Zr,Ti)O_3$, hereinafter referred to as PZT). A piezoelectric body consisting of a perovskite-type oxide is applied as a piezoelectric film in a piezoelectric element having a lower electrode, a piezoelectric film, and an upper electrode on a substrate. This piezoelectric element has been developed into various devices such as a memory, an inkjet head (an actuator), a micromirror device, an angular velocity sensor, a gyro sensor, a piezoelectric micromachined ultrasonic transducer (PMUT), and an oscillation power generation device.

The piezoelectric characteristics greatly change due to the excess or deficiency of oxygen in the perovskite structure of the perovskite-type oxide. In particular, in a perovskite-type oxide containing lead (Pb) such as a PZT film, oxygen is easily eliminated, and the oxygen defect in the piezoelectric film easily causes the deterioration of piezoelectric characteristics and the deterioration of durability. In order to suppress the oxygen elimination in the perovskite-type oxide, it is effective to use a conductive oxide such as SRO ($SrRuO_3$) or $IrO_2$ in regions of the lower electrode and the upper electrode, where these regions are in contact with the piezoelectric film. Further, in a case where a conductive oxide is used in the region in contact with the piezoelectric film, a layer of a noble metal such as platinum (Pt) or iridium (Ir) is generally laminated on the conductive oxide layer in order to ensure good conductivity (see, for example, JP2018-085478A).

JP2007-300071A proposes a piezoelectric element having a PZT film, in which a lower electrode layer has a configuration such that an amount of a conductive oxide is large on a side of a substrate and an amount of a conductive metal is large on a side of a piezoelectric film in order to improve the adhesiveness at each interface between the substrate and the lower electrode layer and between the lower electrode layer and the piezoelectric film. Further, it describes that a Pt group is preferable as the conductive metal contained in the lower electrode layer.

On the other hand, JP2011-103327A proposes a piezoelectric element having a first electrode (corresponding to the lower electrode layer) that does not use a Pt group. In JP2011-103327A, a first conductive layer, a first interlayer consisting of a nitride compound, a second interlayer, and a second conductive layer consisting of a conductive oxide are laminated in the lower electrode layer. Here, the first conductive layer is made of one of Ti, Zr, Hf, V, Nb, Ta, Cr, Mo, W, Mn, Fe, Co, Ni, Cu, Ag, or Au, or an alloy of two or more thereof, and the second interlayer is made of one of Ti, Zr, W, Ta, Al, or an alloy of two or more thereof. JP2011-103327A describes that in a case where a lower electrode layer having such a laminated structure is provided, it is possible to provide a piezoelectric element having an electrode having excellent conductivity and excellent durability as compared with a case where a platinum group is used.

JP2000015809A relates to a piezoelectric laminate comprising a PZT piezoelectric film formed on a stack of intermediate layers. The stack includes a first intermediate layer made of tantalum and a second intermediate layer containing tantalum nitride. Another intermediate layer includes a platinum group metal. This layer is in contact with the PZT film preventing lead diffusion.

**SUMMARY OF THE INVENTION**

As described in JP2018-085478A, in a piezoelectric element having a piezoelectric film of a perovskite-type oxide, it is possible to suppress the deterioration of piezoelectric characteristics in a case where a conductive oxide layer is provided on the side of the piezoelectric film of the electrode layer. Further, as described in JP2018-085478A and JP2007-300071A, a noble metal which is a Pt group is generally used in the lower electrode.

However, since a metal of the platinum group is very expensive, it is difficult to sufficiently suppress the manufacturing cost of a piezoelectric element having an electrode containing the platinum group.

In JP2011-103327A, since the platinum group is not used in the lower electrode layer, the lower electrode layer can be constituted at a lower cost as compared with the case where the platinum group is used. However, due to the fact that the electrode layer has a structure of at least four layers and thus the material cost and the manufacturing process are complicated, it cannot be said that the effect of suppressing the manufacturing cost is sufficient yet.

The present disclosed technology has been made in consideration of the above circumstances, and an object of the present disclosed technology is to provide a piezoelectric laminate and a piezoelectric element, which makes it possible to suppress the deterioration of piezoelectric characteristics and suppress the manufacturing cost as compared with the conventional case.

The piezoelectric laminate of the present invention is defined by the subject matter of the claims.

According to the piezoelectric laminate and the piezoelectric element of the present invention it is possible to provide a piezoelectric laminate and a piezoelectric element, which makes it possible to suppress the deterioration of piezoelectric characteristics and suppress the manufacturing cost as compared with the conventional case.

## BRIEF DESCRIPTION OF THE DRAWINGS

Fig. 1 is a cross-sectional view illustrating a layer configuration of a piezoelectric laminate and a piezoelectric element, according to an embodiment.

Fig. 2 is a graph showing profiles of contents of a Ta element and a N element in a thickness direction of a lower electrode layer in the piezoelectric element illustrated in Fig. 1.

Fig. 3 is a graph showing another profile of the contents of the Ta element in a thickness direction of a lower electrode layer in the piezoelectric element illustrated in Fig. 1.

Fig. 4 is a cross-sectional view illustrating a layer configuration of a piezoelectric laminate and a piezoelectric element, according to an example, which is outside the subject matter of the claims.

Fig. 5 is a graph showing profiles of contents of a Ta element and a N element in a thickness direction of a lower electrode layer in the piezoelectric element of Example 2.

## DESCRIPTION OF THE PREFERRED EMBODIMENTS

Hereinafter, an embodiment of the present invention will be described with reference to the drawings. In the drawings below, the layer thickness of each of the layers and the ratio therebetween are appropriately changed and drawn for easy visibility, and thus they do not necessarily reflect the actual layer thickness and ratio.

Piezoelectric laminate 5 and piezoelectric element 1, according to an embodiment according to the subject matter defined by the claims.

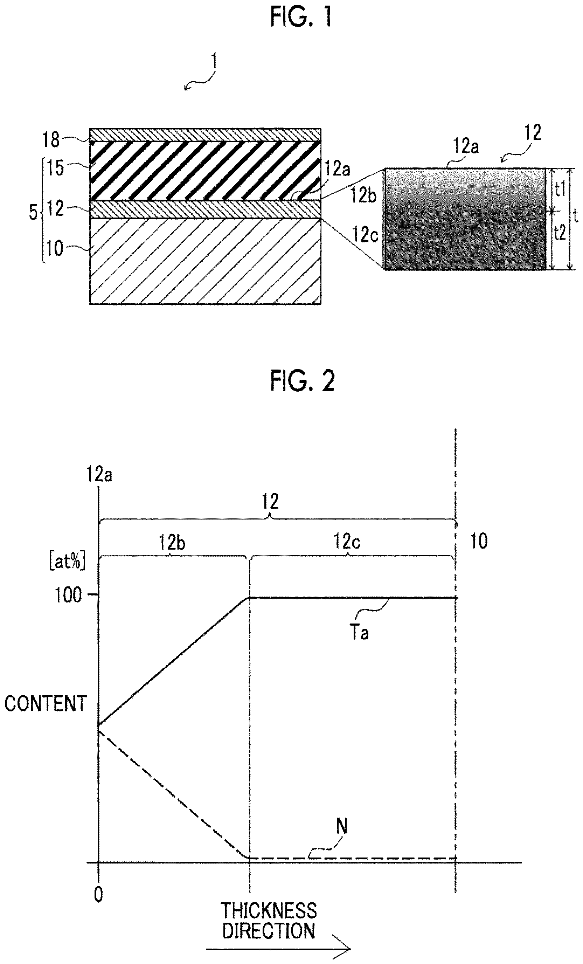

Fig. 1 is a cross-sectional view illustrating layer configurations of a piezoelectric laminate 5 and a piezoelectric element 1 having the piezoelectric laminate 5, according to a first embodiment. As illustrated in Fig. 1, the piezoelectric element 1 has the piezoelectric laminate 5 and an upper electrode layer 18. The piezoelectric laminate 5 has a substrate 10, and a lower electrode layer 12 and a piezoelectric film 15 which are laminated on the substrate 10. Here, "lower" and "upper" do not respectively mean top and bottom in the vertical direction. As result, an electrode arranged on the side of the substrate 10 with the piezoelectric film 15 being interposed is merely referred to as the lower electrode layer 12, and an electrode arranged on the side of the piezoelectric film 15 opposite to the substrate 10 is merely referred to as the upper electrode layer 18.

In the piezoelectric laminate 5, the lower electrode layer 12 contains a Ta element, and it contains a Ta nitride (TaN) on the side closest to the piezoelectric film 15 in the thickness direction of the lower electrode layer 12. Further, as will be described in detail later, the lower electrode layer 12 includes a region where the content of the Ta element changes in the thickness direction, and the change in the content of the Ta element in the thickness direction is continuous. Further, the change in the content of the Ta element in the thickness direction of the lower electrode layer 12 is continuous. Here, "the content of the Ta element in the thickness direction" is a proportion of the Ta element with respect to all elements at each position in the thickness direction, and it is indicated in the unit of at%. The "thickness direction" is a direction perpendicular to the substrate 10. "The change in the content is continuous" means that there are no discontinuous portions in the content profile in the thickness direction (see Fig. 2). Further, "the lower electrode layer 12 contains a Ta element" means that the lower electrode layer 12 contains a Ta element so that it is occupied by 50 at% or more of the metal element among the constituent elements constituting it. In the lower electrode layer 12, it is preferable that among the constituent elements constituting the lower electrode layer 12 other than the Ta element, the content of the element of which the content is 10 at% or more in the entire region of the lower electrode layer 12 is constant or continuously changes in the thickness direction.

The enlarged view in Fig. 1 schematically illustrates the change in the content of the Ta element in the lower electrode layer 12. In the enlarged view in Fig. 1, the larger the content of the Ta element is, the darker the color is, and the smaller the content is, the lighter the color is. Further, Fig. 2 illustrates the change (the content profile) in the content of each of the Ta element and the N element in the thickness direction, contained in the lower electrode layer 12. The horizontal axis indicates the position of the lower electrode layer 12 in the thickness direction. 0 on the horizontal axis is the position (a boundary 12a) in the lower electrode layer 12 on the side closest to the piezoelectric film 15, and the two-dot chain line position is the boundary with respect to the substrate 10.

In the piezoelectric laminate 5 and the piezoelectric element 1 according to the present embodiment, the lower electrode layer 12 has a first region 12b containing a Ta nitride and a second region 12c consisting of Ta metal, provided on the first region 12b side from the substrate 10. The first region 12b includes the boundary 12a with respect to the piezoelectric film 15, which is on the side closest to the piezoelectric film 15.

As shown in Fig. 2, in the present embodiment, the lower electrode layer 12 contains the Ta element over the entire region in the thickness direction. The first region 12b is a region where the content of the Ta element changes in the thickness direction, and the change in the content of the Ta element is in an increasing trend from the side of the piezoelectric film 15 toward the side of the substrate 10. More specifically, the content of the Ta element in the first region 12b exhibits the maximum value (here, substantially 100 at%) on the side closest to the substrate 10 (here, on the side of the second region 12c) in the thickness direction, and it monotonically increases from the boundary 12a, which is on the side closest to the piezoelectric film 15. In the second region 12c, the content of the Ta element is substantially constant in the thickness direction, and it continuously exhibits the maximum value (here, substantially 100 at%) from the boundary with respect to the first region 12b. Here, the increasing trend indicates that in a case where a start point and an end point are compared, the content of the end point is larger than that of the start point, and thus the content tends to increase as a whole. For example, as in Fig. 2, in the content profile in which the side on the left is denoted by the side of the piezoelectric film 15 and the side on the right is denoted by the side of the substrate 10, in a case where the content decreases to cause a portion where the measurement error is exceeded, even such a case is also included in the increasing trend as long as the content is on the rise as a whole. Further, "monotonically increases" means that the content increases without including a case where the content decreases to cause a portion where the measurement error is exceeded in the content profile.

The content of the element in the lower electrode layer 12 can be measured by the secondary ion mass spectrometry (SIMS) analysis, and in the present disclosure, the content of the element is a value measured according to SIMS. Further, since the content fluctuates by about $\pm 5$ at% due to noise in the actual measurement data, the fluctuation of about $\pm 5$ at% is regarded as the range of measurement error.

In the present embodiment, the lower electrode layer 12 is composed of Ta and nitrogen (N) (however, it contains unavoidable impurities), and in the thickness direction of the first region 12b of the lower electrode layer 12, the profile that shows the change in the content of the N element is symmetrical with the profile that shows the change in the content of the Ta element, with the line of the content of 50 at% being the axis of symmetry. That is, the content of the N element continuously decreases from the boundary 12a, which is on the side closest to the piezoelectric film 15, toward the side of the second region 12c, and then exhibits a constant value of almost 0 at%. It is noted that the region (the first region 12b in this example) containing a Ta nitride, which includes, in the lower electrode layer 12, the side closest to the piezoelectric film 15, may contain a Ta oxynitride (TaON). In a case where the lower electrode layer 12 contains TaON, the profile of the N element is, of course, different from that shown in Fig. 2.

In the present embodiment, an example is shown in which almost the whole Ta is nitrided at the boundary 12a of the lower electrode layer 12 with respect to the piezoelectric film 15. However, at the boundary 12a, the nitrided Ta and the non-nitrided Ta may be in a state of being mixed. However, it is preferable that 20 at% or more of the Ta present at the boundary 12a is nitrided, and it is more preferable that 30 at% or more thereof is nitrided. Further, it is preferable that 20 at% or more of the Ta element is present as a nitride in the entire first region 12b.

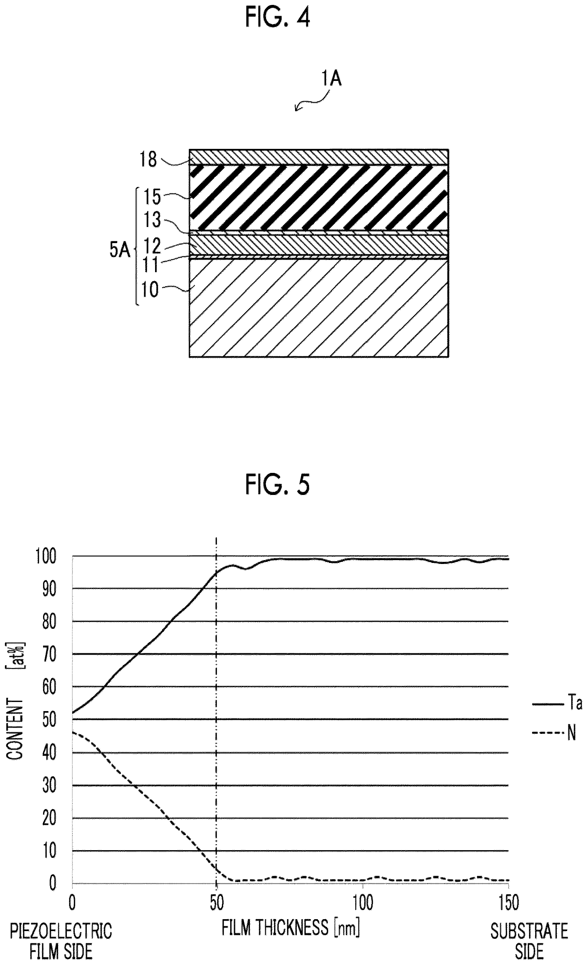

The thickness t of the lower electrode layer 12 is preferably about 50 nm to 300 nm and more preferably 100 nm to 300 nm. The lower electrode layer 12 contains a Ta nitride at least on the side closest to the piezoelectric film 15. However, it preferably contains a Ta nitride in a range of 20 nm or more from the side of the piezoelectric film 15, and more preferably contains a Ta nitride in a range of 30 nm or more from the side closest to the piezoelectric film 15. In order to ensure sufficient conductivity without the thickness t of the lower electrode layer 12 becoming too thick, the range containing the Ta nitride is preferably 60 nm or less from the side closest to the piezoelectric film 15. That is, it is preferable to contain a Ta nitride over 20 nm to 60 nm, and it is particularly preferable to contain a Ta nitride over 40 nm to 60 nm from the side closest to the piezoelectric film 15, in the lower electrode layer 12. In the case of the present embodiment, the thickness t1 of the first region 12b is 20 nm to 60 nm, more preferably 30 nm to 60 nm, and particularly preferably 40 nm to 60 nm. Further, in a case where the lower electrode layer 12 has the first region 12b and the second region 12c as in this example, the thickness t2 of the second region 12c is preferably 50 nm to 200 nm and more preferably 80 nm to 150 nm. The thickness of the lower electrode layer 12 can be estimated from a scanning electron microscope (SEM) image of a cross section and a transmission electron microscope (TEM) or secondary ion mass spectrometry (SIMS) analysis. However, the content of the Ta element continuously changes between the region where the content of the Ta element changes (here, the first region 12b) and the region (here, the second region 12c) where the content of the Ta element does not change, and thus the boundary between the two regions is not clear, for example, in a scanning electron microscopic image. For this reason, the respective thicknesses t1 and t2 of the first region 12b and the second region 12c are determined from the composition distribution in the thickness direction of the lower electrode layer 12 (see Fig. 2 and Fig. 5), that is, from the measurement data of the content change of the constituent elements.

The piezoelectric film 15 contains a perovskite-type oxide. It is preferable that the piezoelectric film 15 is occupied by 80% by mole or more of the perovskite-type oxide. Further, it is preferable that the piezoelectric film 15 is consisting of a perovskite-type oxide (however, it contains unavoidable impurities).

The perovskite-type oxide is represented by the general formula $ABO_3$.

In the general formula, A is an A-site element, which is one of Pb, barium (Ba), lanthanum (La), Sr, bismuth (Bi), lithium (Li), sodium (Na), calcium (Ca), cadmium (Cd), magnesium (Mg), or potassium (K), or a combination of two or more thereof.

In the general formula, B is a B-site element, which is one of Ti, Zr, vanadium (V), Nb, Ta, chromium (Cr), molybdenum(Mo), tungsten (W), manganese (Mn), iron (Fe), Ru, cobalt (Co), Ir, nickel (Ni), copper (Cu), zinc (Zn), gallium (Ga), In, Sn, antimony (Sb), or a lanthanide element, or a combination of two or more thereof.

In the general formula, O is oxygen.

Regarding A:B:O, a reference ratio thereof is 1:1:3; however, it suffices that the ratio is in a range in which a perovskite structure is obtained.

It is particularly preferable that the piezoelectric film 15 contains Pb as the main component of the A site. It is noted that in the present specification, "the main component" means a component of which the occupation is 50% by mole or more. That is, "contains Pb as the main component of the A site" means that the component having 50% by mole or more among the A site elements is Pb. In the perovskite-type oxide containing Pb, the elements in the A site other than Pb and the elements of the B site are not particularly limited.

The perovskite-type oxide is preferably a lead zirconate titanate (PZT) type that contains lead (Pb), zirconium (Zr), titanium (Ti), and oxygen (O).

In particular, it is preferable that the perovskite-type oxide is a compound represented by General Formula (P), which contains an additive B1 in the B site of PZT.

$$Pb\{(Zr_xTi_{1-x})_{1-y}B1_y\}O_3 \qquad (P)$$

Here, $0 < x < 1$ and $0 < y < 0.3$ are satisfied. It is noted that regarding $Pb:\{(Zr_xTi_{1+x})_{1-y}B_y\}:O$ in General Formula (P), a reference ratio thereof is 1:1:3; however, it suffices that the ratio is in a range in which a perovskite structure is obtained.

Examples of the B1 include scandium (Sc), V, Nb, Ta, Cr, Mo, W, Mn, Fe, Ru, Co, Ir, Ni, Cu, Zn, Ga, In, Sn, and Sb. It is preferable to contain one or more elements among these elements. B1 is more preferably any one of Sc, Nb, or Ni.

In particular, it is preferable that B1 is Nb and that the perovskite-type oxide contains Nb. A compound represented by General Formula (1) is particularly preferable.

$$Pb\{(Zr_xTi_{1-x})_{1-y}Nb_y\}O_3 \qquad (1)$$

$$0 < x < 1, \ 0.1 \le y \le 0.4$$

The film thickness of the piezoelectric film 15 is not particularly limited, and it is generally 200 nm or more, for example, 0.2 μm to 5 μm. The film thickness of the piezoelectric film 15 is preferably 1 μm or more.

The substrate 10 is not particularly limited, and examples thereof include substrates such as silicon, glass, stainless steel, yttrium-stabilized zirconia, alumina, sapphire, and silicon carbide. As the substrate 10, a laminated substrate having a $SiO_2$ oxide film formed on the surface of the silicon substrate may be used.

The upper electrode layer 18 is paired with the lower electrode layer 12 and is an electrode for applying a voltage to the piezoelectric film 15. The main component of the upper electrode layer 18 is not particularly limited, and examples thereof include metals such as gold (Au), platinum (Pt), iridium (Ir), ruthenium (Ru), titanium (Ti), molybdenum (Mo), tantalum (Ta), aluminum (Al), copper (Cu), silver (Ag), chromium (Cr), such as zinc (Zr), and metal oxides thereof, as well as combinations thereof. Further, as the upper electrode layer 18, indium tin oxide (ITO), IGZO, $LaNiO_3$, SRO (which may contain Ba), or the like may be used. The upper electrode layer 18 may be a single layer or may have a laminated structure composed of a plurality of layers. It is noted that from the viewpoint of suppressing oxygen diffusion from the piezoelectric film 15, at least a region of the upper electrode layer 18, which is in contact with the piezoelectric film, is preferably an oxide electrode.

The layer thickness of the upper electrode layer 18 is not particularly limited, and it is preferably about 50 nm to 300 nm and more preferably 100 nm to 300 nm.

As described above, in the piezoelectric laminate 5 and the piezoelectric element 1 according to the present embodiment, the lower electrode layer 12 contains a Ta element and contains a Ta nitride on the side closest to the piezoelectric film 15 in the thickness direction. In a case where the region in the lower electrode layer 12 on the side closest to the piezoelectric film 15 is a metal layer, oxygen in the piezoelectric film 15 may leak and migrate to the side of the lower electrode layer 12, thereby oxidizing the metal of the lower electrode layer 12. Further, in a case of carrying out the film formation of the piezoelectric film 15 on the lower electrode layer 12, oxygen remaining in the atmosphere may be incorporated into the surface of the lower electrode layer 12, whereby the metal on the surface layer of the lower electrode layer 12 is oxidized. In particular, in a case where the metal is Ta, Ta is oxidized to form $Ta_2O_5$, which is an insulator, and thus the conductivity is significantly deteriorated. In a case where an insulating layer is formed in the boundary region in the lower electrode layer 12 on the side of the piezoelectric film 15, the performance as an electrode is deteriorated, and the performance (piezoelectric characteristics) of the piezoelectric element 1 is deteriorated. However, since the piezoelectric laminate 5 and the piezoelectric element 1 according to the present embodiment contain a Ta nitride on the side closest to the piezoelectric film 15, the oxidation of Ta is suppressed, and as a result, the deterioration of piezoelectric characteristics can be suppressed. Further, since the oxygen element hardly leaks from the piezoelectric film 15, the effect of improving long-term stability can be obtained. It is noted that even in a case where the Ta nitride is partially oxidized to become a Ta oxynitride (TaON), the Ta oxynitride is not an insulator, and thus the deterioration of the function of the lower electrode layer 12 is small as compared with the case where $Ta_2O_5$ is formed.

Further, the lower electrode layer 12 includes a region (here, the first region 12b) where the content of the Ta element changes in the thickness direction, and the change in the content of the Ta element in the thickness direction is continuous. In a case where the change in the content of the Ta element in the thickness direction is discontinuous, the adhesiveness may be deteriorated at the discontinuous portion, whereby peeling may occur. However, in the present embodiment, the change in the content of the Ta element in the lower electrode layer 12 is continuous, and thus the occurrence of peeling can be suppressed.

Further, since Ta is used as a metal species of the lower electrode layer 12, the cost can be significantly reduced as compared with the piezoelectric element in the related art, in which a metal of the Pt group has been used as the main component.

Further, in the present embodiment, the change in the content of the Ta element in the lower electrode layer 12 is in an increasing trend from the side of the piezoelectric film toward the side of the substrate. In the region in the lower electrode layer 12 on the side closest to the piezoelectric film 15, the closer the content ratio of Ta to N is to that of TaN, that is, 1: 1, which is the stoichiometric ratio in the Ta nitride, the higher the effect of suppressing oxidation is. On the other hand, the higher the proportion of the non-nitrided metal Ta in the lower electrode layer 12 is, the higher the conductivity is, and the higher the functionality is as the lower electrode layer 12. As a result, in a case where the content of the Ta element is in an increasing trend from the side of the piezoelectric film 15 toward the substrate 10 as in the present embodiment, the effect of suppressing the generation of the oxygen defect in the piezoelectric film 15 can be enhanced, and the effect of suppressing the deterioration of conductivity can be suppressed.

Furthermore, in the piezoelectric laminate 5 and the piezoelectric element 1 according to the above embodiment, in the region where the content of the Ta element of the lower electrode layer 12 changes, the content of the Ta element exhibits the maximum value on the side closest to the substrate 10 in the thickness direction and monotonically increases from the side of the piezoelectric film 15. According to this configuration, it is possible to enhance the effect of suppressing the migration of oxygen from the piezoelectric film 15 to the lower electrode layer 12 and the effect of suppressing the deterioration of conductivity.

In a case where the lower electrode layer 12 contains a Ta nitride in a range of 20 nm to 60 nm from the side closest to the piezoelectric film 15, it is possible to further enhance the effect of suppressing the oxygen migration from the piezoelectric film 15 to the lower electrode layer 12 and suppress the deterioration of piezoelectric characteristics.

In the above embodiment, although the metal species contained in the lower electrode layer 12 is only Ta, a metal species other than Ta may be contained. Examples of the metal element other than the Ta element include Cu, Al, Ti, Ni, Cr, and Fe. Further, the lower electrode layer 12 may contain C or Si. However, in a case of forming the lower electrode layer 12 only with Ta element and N element, it is possible to reduce the number of kinds of materials and simplify the manufacturing method as well, and thus the effect of cost reduction is high.

As described above, in the piezoelectric laminate 5 and the piezoelectric element 1 according to the above embodiment, the lower electrode layer 12 has the first region 12b where the Ta element continuously increases from the side of the piezoelectric film 15 toward the side of the substrate 10 and the second region 12c consisting of the Ta metal, where the change in the content of the Ta element is as shown in Fig. 2. However, the change in the content of the Ta element in the thickness direction of the lower electrode layer 12 is not limited to that shown in Fig. 2.

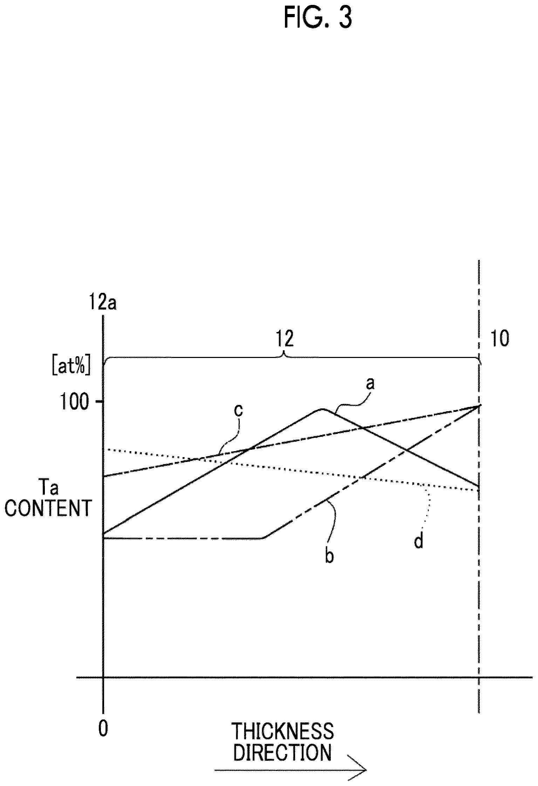

Fig. 3 shows other examples (profiles a to d) of the change in the content of the Ta element in the thickness direction of the lower electrode layer 12. In Fig. 3, as in Fig. 2, the horizontal axis indicates the position of the lower electrode layer 12 in the thickness direction. 0 on the horizontal axis is the position (a boundary 12a) in the lower electrode layer 12 on the side closest to the piezoelectric film 15, and the two-dot chain line position is the boundary with respect to the substrate 10. Although not illustrated in Fig. 3, the respective profiles of the N element are, for example, symmetrical with the profile of the Ta element, with the line of the content of 50 at% being as the central axis.

As shown in the profile a of Fig. 3, the content of the Ta element in the thickness direction of the lower electrode layer 12 is about 50 at% at the boundary 12a with respect to the piezoelectric film 15, and it gradually increases toward the side of the substrate 10 to take the maximum value. Then, the maximum value may decrease toward the side of the substrate 10. In the profile a, the entire region in the thickness direction is a region where the content of the Ta element changes.

In addition, as shown in the profile b of Fig. 3, the content of the Ta element in the thickness direction of the lower electrode layer 12 is about 50 at% at the boundary 12a with respect to the piezoelectric film 15, and it exhibits a constant value for a while from the boundary 12a toward the side of the substrate 10. Then, it may monotonically increase toward the side of the substrate 10 to take the maximum value. In the profile b, the region where the increase is monotonic is a region where the content of the Ta element changes.

In the embodiment and profiles a and b, which are described above, the content of the Ta element is substantially 50 at% in the lower electrode layer 12 on the side closest to the piezoelectric film 15. In a case where the lower electrode layer 12 is composed of Ta and N, the content of the Ta element is 50 at%, and the content of the N element is 50 at% in a case where the Ta element is completely nitrided at the boundary 12a on the side of the piezoelectric film 15. In this case, the non-nitrided Ta element is not present, and thus the effect of suppressing oxidation due to oxygen in the piezoelectric film 15 is high.

However, as shown in the profile c of Fig. 3, the content of the Ta element at the boundary 12a in the lower electrode layer 12 on the side closest to the piezoelectric film 15 is not limited to 50 at%, and it may be larger than 50 at%. Further, as shown in the profile c of Fig. 3, the content of the Ta element may continuously increase from the side closest to the piezoelectric film 15 toward the side of the substrate 10 over the entire region of the lower electrode layer 12 in the thickness direction. Further, as shown in the profile d of Fig. 3, the content of the Ta element may decrease from the side closest to the piezoelectric film 15 toward the side of the substrate 10 over the entire region of the lower electrode layer 12 in the thickness direction.

In any one of the profiles a to d, the lower electrode layer 12 contains a Ta element, and it contains a Ta nitride on the side closest to the piezoelectric film 15 in the thickness direction of the lower electrode layer 12. Further, it includes a region where the content of the Ta element changes in the thickness direction, and the change in the content of the Ta element in the thickness direction is continuous. In any case, the Ta nitride is contained on the side closest to the piezoelectric film 15, and thus oxidation is suppressed and the deterioration of piezoelectric characteristics can be suppressed. Further, since the oxygen element hardly leaks from the piezoelectric film 15, the effect of improving long-term stability can be obtained. Further, since the change in the content of the Ta element in the lower electrode layer 12 is continuous, the occurrence of peeling can be suppressed. Furthermore, since Ta is used as a metal species of the lower electrode layer 12, the cost can be significantly reduced as compared with the piezoelectric element in the related art, in which a metal of the Pt group has been used as the main component.

In addition, regarding the profiles a to c, the change in the content of the Ta element in the thickness direction is in increasing trend, the effect of suppressing oxidation on the side of the piezoelectric film is obtained, and the effect of suppressing the deterioration of conductivity is obtained as well.

Piezoelectric laminate 5A and piezoelectric element 1A of an example, which is outside the subject matter of the claims

Fig. 4 is a cross-sectional schematic view illustrating a piezoelectric laminate 5A and a piezoelectric element 1A having the piezoelectric laminate 5A, according to an example. In Fig. 4, the same reference numerals are respectively assigned to the same constituent elements as those of the piezoelectric laminate 5 and the piezoelectric element 1 according to the embodiment shown in Fig. 1, and the detailed description thereof will be omitted.

As illustrated in Fig. 4, the piezoelectric laminate 5A and the piezoelectric element 1A have an intimate attachment layer 11 between the substrate 10 and the lower electrode layer 12. Further, an alignment control layer 13 is provided between the lower electrode layer 12 and the piezoelectric film 15.

The intimate attachment layer 11 is provided for improving the adhesiveness between the substrate 10 and the lower electrode layer 12 and suppressing peeling. For the intimate attachment layer 11, Ti, W, TiW, or the like is preferably used.

The alignment control layer 13 is formed on the lower electrode layer 12. The alignment control layer 13 is a layer provided for suppressing the generation of a pyrochlore phase that is easily formed at the initial stage of film formation of the piezoelectric film 15 and obtaining a good perovskite-type oxide. The alignment control layer 13 contains a metal oxide. The metal oxide preferably contains at least one of Sr or Ba.

Further, as the alignment control layer 13, it is preferable to use, for example, the growth control layer described in WO2020/250591A, WO2020/250632A, JP2020-202327A, or the like.

That is, the alignment control layer 13 preferably contains a metal oxide represented by General Formula (2).

$$Ma_d Mb_{1-d} O_e \qquad (2)$$

Ma is one or more metal elements that can be replaced with the metal in the A site of the perovskite-type oxide.

Mb consists of metal species that can be replaced with the metal in the B site of the perovskite-type oxide, where the main component thereof is one of Sc, Zr, V, Ta, Cr, Mo, W, Mn, Fe, Ru, Co, Ir, Ni, Cu, Zn, Cd, Ga, In, or Sb.

O is an oxygen element.

In addition, here, each of d and e indicates a composition ratio, and $0 < d < 1$ and e change depending on the valences of Ma and Mb.

Specific examples of the substance of the alignment control layer 13 include $BaRuO_3$ and $SrRuO_3$.

The thickness of the alignment control layer 13 is preferably 2 nm or more and 20 nm or less and more preferably about 10 nm.

Also in the piezoelectric laminate 5A and the piezoelectric element 1A according to the present example, the configuration of the lower electrode layer 12 is the same as that in the piezoelectric laminate 5 and the piezoelectric element 1 according to the embodiment That is, the lower electrode layer 12 contains a Ta element, contains a Ta nitride on the side closest to the piezoelectric film 15 in the thickness direction of the lower electrode layer 12, and includes a region where the content of the Ta element changes in the thickness direction, and the change in the content of the Ta element in the thickness direction is continuous. Since Ta nitride is contained on the side closest to the piezoelectric film 15, oxidation is suppressed and the deterioration of piezoelectric characteristics can be suppressed. Further, since the oxygen element hardly leaks from the piezoelectric film 15, the effect of improving long-term stability can be obtained. Since the change in the content of the Ta element in the lower electrode layer 12 is continuous, the occurrence of peeling can be suppressed. Furthermore, since Ta is used as a metal species of the lower electrode layer 12, the cost can be significantly reduced as compared with the piezoelectric element in the related art, in which a metal of the Pt group has been used as the main component.

Further, the piezoelectric laminate 5A and the piezoelectric element 1A according to the present example have the alignment control layer 13, and the piezoelectric film 15 is formed on the alignment control layer 13. As a result, it is possible to suppress the generation of the pyrochlore phase that is easily formed at the initial stage of film formation. Since the generation of the pyrochlore phase at the interface of the piezoelectric film 15 on side of the lower electrode layer 12 can be suppressed, the piezoelectric characteristics of the piezoelectric film 15 are good, and thus it is possible to obtain a high piezoelectric constant and high piezoelectricity as compared with a case where the alignment control layer 13 is not present.

The piezoelectric elements 1 and 1A or the piezoelectric laminates 5 and 5A according to each of the embodiment or examples can be applied to an ultrasonic device, a mirror device, a sensor, a memory, and the like.

Examples

Hereinafter, specific examples and comparative examples of the piezoelectric element of the present disclosure will be described. First, a manufacturing method for a piezoelectric element of each example will be described. It is noted that the conditions other than the configuration of the lower electrode layer and the presence or absence of the alignment control layer are common in each example. In addition, a radio frequency (RF) sputtering device was used for the film formation of each layer.

Manufacturing method

Substrate

A 6-inch (15.24 cm) Si wafer attached with a thermal oxide film was used as the substrate.

Lower electrode layer

A lower electrode layer was formed on the thermal oxide film of the substrate. The film formation conditions for the lower electrode layer in each example were as follows. The back pressure [Pa] and the film formation temperature in each example were set as shown in Table 1.

Reference example

Before the film formation of the lower electrode layer, a film of 20 nm of TiW was formed on the thermal oxide film of the substrate as an intimate attachment layer. Then, a film of 150 nm of Ir was formed on the TiW layer as the lower electrode layer under the conditions of an Ar gas of 60 sccm (standard cubic centimeres per minute = $1 \text{ cm}^3/\text{min}$) an RF electric power of 300 W, and a film formation pressure of 0.25 Pa.

Comparative Example 1

A film of 150 nm of Ta was formed on the thermal oxide film of the substrate under the conditions of an Ar gas of 60 sccm, an RF electric power of 300 W, and a film formation pressure of 0.25 Pa. In Comparative Example 1, the lower electrode layer was a single layer of a Ta metal layer.

Comparative Example 2

A film of 100 nm of Ta was formed on the thermal oxide film of the substrate under the conditions of an Ar gas of 60 sccm, an RF electric power of 300 W, and a film formation pressure of 0.25 Pa. Subsequently, a film of 50 nm of a Ta nitride was formed on the Ta layer under the conditions of an Ar gas of 30 sccm, a $N_2$ gas of 30 sccm, an RF electric power of 300 W, and a film formation pressure of 0.25 Pa. That is, in Comparative Example 2, the lower electrode layer had a two-layer structure of a Ta metal layer and a Ta nitride layer having a constant composition provided on an upper layer of the Ta metal layer.

Examples 1 to 6

A film of 100 nm of Ta was formed under the conditions of an Ar gas of 60 sccm, an RF electric power of 300 W, and a film formation pressure of 0.25 Pa. Subsequently, for each example, a film of a Ta nitride was formed to have the thickness shown in Table 1 under the conditions of an RF electric power of 300 W and a film formation pressure of 0.25 Pa, while gradually reducing the Ar gas from 60 sccm to 30 sccm and at the same time gradually increasing the $N_2$ gas from 0 sccm to 30 sccm. In a case where after the film formation of the Ta metal layer, a film of a Ta nitride is formed by continuously changing the flow amounts of the Ar gas and the $N_2$ gas, the content of the Ta element gradually increases from the surface toward the metal layer, which makes it possible to form a film of a Ta nitride layer in which the content of the N element gradually decreases (see Fig. 5). That is, in Examples 1 to 6, the lower electrode layer had a laminated structure of a Ta metal layer (the second region in the embodiment) and a composition gradient layer (the first region in the embodiment) in which the content of the Ta element and the amount of the N element gradually change. In Table 1, in the item of the layer configuration of the lower electrode layer, the description is made in the order of the first region / the second region. In Table 1, TaN (gradient, 50 nm) indicates that the first region is a region of an oxynitride and is a gradient layer having a thickness of 50 nm. The content of the Ta element continuously changed between the Ta metal layer and the composition gradient layer and in the composition gradient layer, and thus a seamless lower electrode layer was obtained.

Alignment control layer

In Example 3, Ar was allowed to flow on the lower electrode layer so that the substrate temperature was 500°C and the film formation pressure was 0.8 Pa, and then a film of 10 nm of $BaRuO_3$ was formed as the alignment control layer.
In Example 4, Ar was allowed to flow on the lower electrode layer so that the substrate temperature was 500°C and the film formation pressure was 0.8 Pa, and then a film of 10 nm of $SrRuO_3$ was formed as the alignment control layer.
It is noted that the alignment control layer is not provided in other examples, the reference example and the comparative examples.

Piezoelectric film

An Nb-doped PZT film having a thickness of 2 $\mu$m was formed as the piezoelectric film on the lower electrode layer or the alignment control layer with a radio frequency (RF) sputter. The substrate temperature at the time of film formation was set to 550°C, and the $O_2$ gas flow rate ratio in the sputtering gas was set to 3% with respect to the Ar gas. In addition, the RF electric power was set to 1 kW.
A laminated substrate in which a lower electrode and a piezoelectric film were laminated on the substrate was obtained as described above. It is noted that regarding the laminated substrates of each example and comparative example, a diffraction pattern due to X-ray diffraction was acquired by an X-ray diffractometer manufactured by Malvern Panalytical, whereby it was confirmed that the piezoelectric film has a perovskite type structure.

Upper electrode layer

An ITO layer having a thickness of 100 nm was formed on the piezoelectric film of the above-described laminated substrate with a sputter.

Measurement of element distribution in lower electrode layer

The element distribution in the thickness direction of the lower electrode layer can be measured according to a secondary ion mass spectrometry (SIMS) analysis. As an example, the data obtained according to the SIMS analysis using a sample having the lower electrode layer of Example 2 is shown in Fig. 5. The sample was irradiated with an $Ar^+$ ion, and the analysis was carried out while cutting the sample from the surface side of the Ta nitride layer.

In Fig. 5, the horizontal axis is the position in the thickness direction of the lower electrode layer, 0 is the surface position of the lower electrode layer, and the closer to the side on the right of the horizontal axis is, the closer to the substrate is. As shown in Fig. 5, at the surface position of the lower electrode layer, the contents of both the Ta element and the N element were in the vicinity of 50 at%. The content of the Ta element gradually increased from the surface toward the side of the substrate and reached substantially 100 at% at about 50 nm, exhibiting a constant value. On the other hand, the content of the N element gradually decreased from the surface toward the side of the substrate and reached substantially 0 at% at about 50 nm, exhibiting a constant value. It is revealed that in a case where in the lower electrode layer of Example 2, the flow rate ratio between the Ar gas and the $N_2$ gas is gradually changed at the time of film formation of the gradient layer, it is possible to obtain a profile in which the contents of the Ta element and the N element gradually change in the thickness direction as illustrated in Fig. 5.

Measurement of dielectric constant

Preparation of measurement sample

The laminated substrate was subjected to dicing processing to a size of an one-inch (25.4 mm) square to produce a piezoelectric laminate of an one-inch square. It is noted that at the time of film formation of the upper electrode layer, a metal mask partially having a circular opening having a diameter of 400 μm was used to form a circular upper electrode layer having a diameter of 400 μm. Then, an one-inch square in which a circular upper electrode layer was provided at the center was cut out and used as a sample for dielectric constant measurement.

Measurement

An impedance analyzer manufactured by Agilent Technologies, Inc. was used to measure the dielectric constant. An alternating current voltage having a frequency of 1 kHz was applied to the piezoelectric element of each example, and the dielectric constant was calculated from the measured impedance value. The obtained dielectric constants are shown in Table 1.

Measurement of piezoelectric constant

Preparation of measurement sample

A strip-shaped portion having a size of 2 mm × 25 mm was cut out from the laminated substrate to produce a cantilever.

Measurement

According to the method described in I. Kanno et. al. Sensor and Actuator A 107 (2003) 68, the piezoelectric constant was measured using the cantilever, by using an applied voltage of a sine wave of -10 V ± 10 V, that is, a bias voltage of -10 V and an applied voltage of a sine wave having an amplitude of 10V, and the obtained results thereof are shown in Table 1.

Table 1 summarizes the piezoelectric element configurations and evaluations of the respective examples. The reference example is a piezoelectric element having a lower electrode layer consisting of Ir, which has been used in the related art, and it is an example in which the dielectric constant and the piezoelectric constant are good. In Table 1, the ratios of the dielectric constant and the piezoelectric constant for each example and comparative example to the value of the reference example are shown together.

[Table 1]

| Item | Lower electrode layer | | | | Evaluation of piezoelectric element | | | |
|---|---|---|---|---|---|---|---|---|
| | Layer configuration (thickness) | Back pressure [Pa] | Film formation temperature [°C] | Alignment control layer | Dielectric constant $\varepsilon$ | Dielectric constant $\varepsilon$/ dielectric constant of reference example [%] | Piezoelectric constant $d_{31}$ [pm/V] | Piezoelectric constant $d_{31}$/ dielectric constant of reference example [%] |
| Reference Example | Ir (150 nm) | $9.20 \times 10^{-6}$ | 300 | Absent | 1280 | 100 | 229 | 100 |
| Comparative Example 1 | Ta (150 nm) | $8.00 \times 10^{-6}$ | 300 | Absent | 1020 | 80 | 195 | 85 |
| Comparative Example 2 | TaN (50 nm)/Ta (100 nm) | $8.00 \times 10^{-6}$ | 300 | Absent | - | - | - | - |
| Example 1 | TaN (gradient, 50 nm)/Ta (100 nm) | $8.50 \times 10^{-6}$ | RT | Absent | 1240 | 97 | 223 | 97 |
| Example 2 | TaN (gradient, 50 nm)/Ta (100 nm) | $700 \times 10^{-5}$ | 300 | Absent | 1260 | 98 | 225 | 98 |
| Example 3 | TaN (gradient, 50 nm)/Ta (100 nm) | $8.80 \times 10^{-5}$ | 300 | $BaRuO_3$ | 1288 | 101 | 231 | 101 |
| Example 4 | TaN (gradient, 50 nm)/Ta (100 nm) | $9.10 \times 10^{-5}$ | 300 | $SrRuO_3$ | 1281 | 100 | 228 | 100 |
| Example 5 | TaN (gradient, 20 nm)/Ta (100 nm) | $8.90 \times 10^{-5}$ | 300 | Absent | 1230 | 96 | 217 | 95 |
| Example 6 | TaN (gradient, 30 nm)/Ta (100 nm) | $9.05 \times 10^{-5}$ | 300 | Absent | 1239 | 97 | 223 | 97 |

As in Comparative Example 1, in a case where the lower electrode layer is a Ta metal layer, the dielectric constant is low by 20% and the piezoelectric constant is low by 15% as compared with the reference example having an Ir metal layer as the lower electrode layer. Comparative Example 2 has, as a lower electrode layer, the second region consisting of Ta and the first region consisting of a Ta nitride, and the first region has a substantially constant composition in the thickness direction. As a result, in Comparative Example 2, the content of the Ta element is discontinuous at the boundary between the first region and the second region. In the element of Comparative Example 2, peeling occurred, and thus the dielectric constant and the piezoelectric constant could not be measured.

In the piezoelectric elements of Examples 1 to 6, peeling did not occur, and thus it was possible to measure the dielectric constant and the piezoelectric constant. This is conceived to be because the change in the content of the Ta element in the thickness direction of the lower electrode layer is continuous.

It is revealed that in the piezoelectric elements of Examples 1 to 6, the dielectric constant and the piezoelectric constant are reduced by only 5% or less as compared with the reference example, and thus a good dielectric constant and a good piezoelectric constant are provided. In particular, in Examples 3 and 4 having the alignment control layer, it is possible to obtain a dielectric constant and a piezoelectric constant which are comparable to those of the case where the Ir electrode layer is provided. In Examples 1 to 6, only Ta is used as the metal species in the lower electrode layer, and thus the material cost can be significantly suppressed as compared with the piezoelectric element using Ir in the related art. It is revealed that as shown in Examples 1 to 6, according to the present disclosed technology, it is possible to provide a piezoelectric element that exhibits piezoelectric characteristics comparable to those of the piezoelectric element in the related art using Ir in the lower electrode layer, and with which the manufacturing cost can be significantly reduced.

Explanation of References

1, 1A: piezoelectric element
5, 5A: piezoelectric laminate
10: substrate
11: intimate attachment layer
12: lower electrode layer
12a: boundary in lower electrode layer on side of piezoelectric film
12b: first region
12c: second region
13: alignment control layer
15: piezoelectric film
18: upper electrode layer

**Claims**

1. A piezoelectric laminate (5, 5A) comprising, on a substrate (10) in the following order:

   a lower electrode layer (12); and
   a piezoelectric film (15) containing a perovskite-type oxide,
   wherein the lower electrode layer (12) contains a Ta element, contains a Ta nitride on a side closest to the piezoelectric film (15) in a thickness direction of the lower electrode layer (12), and includes a region (12b) where a content of the Ta element changes in the thickness direction, and
   the change in the content of the Ta element in the thickness direction is continuous;
   wherein the lower electrode layer (12) contains the Ta nitride in a range of 20 nm to 60 nm from the side closest to the piezoelectric film (15), and
   wherein the Ta nitride on the side closest to the piezoelectric film is in direct contact with the piezoelectric film.

2. The piezoelectric laminate (5, 5A) according to claim 1,
   wherein the change in the content of the Ta element is in an increasing trend from a side of the piezoelectric film to a side of the substrate.

3. The piezoelectric laminate (5, 5A) according to claim 1 or 2,
   wherein in the region (12b), the content of the Ta element exhibits a maximum value on a side closest to the substrate

(10) in the thickness direction and monotonically increases from a side of the piezoelectric film (15).

**4.** The piezoelectric laminate (5, 5A) according to any one of claims 1 to 3,
wherein the perovskite-type oxide contains Pb, Zr, Ti, and O.

**5.** The piezoelectric laminate (5, 5A) according to claim 4,
wherein the perovskite-type oxide contains Nb.

**6.** The piezoelectric laminate (5, 5A) according to claim 5,
wherein the perovskite-type oxide is a compound represented by General Formula (1),

$$Pb\{(Zr_xTi_{1-x})_{1-y}Nb_y\}O_3 \qquad (1)$$

$$0 < x < 1, \, 0.1 \leq y \leq 0.4.$$

**7.** A piezoelectric element (1, 1A) comprising:

the piezoelectric laminate (5, 5A) according to any one of claims 1 to 6; and
an upper electrode layer (18) provided on the piezoelectric film (15) of the piezoelectric laminate (5, 5A).


**Patentansprüche**

**1.** Piezoelektrisches Laminat (5, 5A), umfassend, auf einem Substrat (10) in der folgenden Reihenfolge:

eine untere Elektrodenschicht (12); und
einen piezoelektrischen Film (15), der ein Oxid vom Perowskit-Typ enthält,
wobei die untere Elektrodenschicht (12) ein Ta-Element enthält, ein Ta-Nitrid auf einer Seite enthält, die dem
piezoelektrischen Film (15) in einer Dickenrichtung der unteren Elektrodenschicht (12) am nächsten ist, und
einen Bereich (12b) beinhaltet, in dem sich ein Gehalt des Ta-Elements in der Dickenrichtung ändert, und
die Änderung des Gehalts des Ta-Elements in der Dickenrichtung kontinuierlich ist;
wobei die untere Elektrodenschicht (12) das Ta-Nitrid in einem Bereich von 20 nm bis 60 nm von der Seite, die
dem piezoelektrischen Film (15) am nächsten ist, enthält, und
wobei das Ta-Nitrid auf der Seite, die dem piezoelektrischen Film am nächsten ist, in direktem Kontakt mit dem
piezoelektrischen Film ist.

**2.** Piezoelektrisches Laminat (5, 5A) nach Anspruch 1,
wobei die Änderung des Gehalts des Ta-Elements in einer zunehmenden Tendenz von einer Seite des piezoelektrischen Films zu einer Seite des Substrats ist.

**3.** Piezoelektrisches Laminat (5, 5A) nach Anspruch 1 oder 2,
wobei in dem Bereich (12b) der Gehalt des Ta-Elements auf einer Seite, die dem Substrat (10) in der Dickenrichtung
am nächsten ist, einen Maximalwert aufweist und von einer Seite des piezoelektrischen Films (15) monoton zunimmt.

**4.** Piezoelektrisches Laminat (5, 5A) nach einem der Ansprüche 1 bis 3,
wobei das Oxid vom Perowskit-Typ Pb, Zr, Ti und O enthält.

**5.** Piezoelektrisches Laminat (5, 5A) nach Anspruch 4,
wobei das Oxid vom Perowskit-Typ Nb enthält.

**6.** Piezoelektrisches Laminat (5, 5A) nach Anspruch 5,
wobei das Oxid vom Perowskit-Typ eine Verbindung ist, die durch die allgemeine Formel (1) dargestellt ist,

$$Pb\{(Zr_xTi_{1-x})_{1-y}Nb_y\}O_3 \qquad (1)$$

$$0 < x < 1, \, 0{,}1 \leq y \leq 0{,}4.$$

**7.** Piezoelektrisches Element (1, 1A), umfassend:

das piezoelektrische Laminat (5, 5A) nach einem der Ansprüche 1 bis 6; und
eine obere Elektrodenschicht (18), die auf dem piezoelektrischen Film (15) des piezoelektrischen Laminats (5, 5A) bereitgestellt ist.


**Revendications**

**1.** Stratifié piézoélectrique (5, 5A) comprenant, sur un substrat (10) dans l'ordre suivant :

une couche d'électrode inférieure (12) ; et
un film piézoélectrique (15) contenant un oxyde de type pérovskite,
ladite couche d'électrode inférieure (12) contenant un élément Ta, contenant un nitrure de Ta sur le côté le plus proche du film piézoélectrique (15) dans le sens de l'épaisseur de la couche d'électrode inférieure (12), et comprenant une zone (12b) dans laquelle la teneur d'élément Ta change dans le sens de l'épaisseur, et le changement de teneur de l'élément Ta dans le sens de l'épaisseur étant continu ;
ladite couche d'électrode inférieure (12) contenant le nitrure de Ta dans la plage de 20 nm à 60 nm depuis le côté le plus proche du film piézoélectrique (15), et
ledit nitrure de Ta sur le côté le plus proche du film piézoélectrique étant en contact direct avec le film piézoélectrique.

**2.** Stratifié piézoélectrique (5, 5A) selon la revendication 1,
ledit changement de teneur de l'élément Ta se présentant sous la forme d'une tendance croissante d'un côté du film piézoélectrique à un côté du substrat.

**3.** Stratifié piézoélectrique (5, 5A) selon la revendication 1 ou 2,
dans la zone (12b), ladite teneur de l'élément Ta présentant une valeur maximale sur un côté le plus proche du substrat (10) dans le sens de l'épaisseur et augmentant de manière monotonique depuis un côté du film piézoélectrique (15).

**4.** Stratifié piézoélectrique (5, 5A) selon l'une quelconque des revendications 1 à 3,
ledit oxyde de type pérovskite contenant Pb, Zr, Ti et O.

**5.** Stratifié piézoélectrique (5, 5A) selon la revendication 4,
ledit oxyde de type pérovskite contenant Nb.

**6.** Stratifié piézoélectrique (5, 5A) selon la revendication 5,
ledit oxyde de type pérovskite étant un composé représenté par la formule générale (1),

$$Pb\{(Zr_xTi_{1-x})_{1-y}Nb_y\}O_3 \qquad (1)$$

$$0 < x < 1,\ 0{,}1 \leq y \leq 0{,}4.$$

**7.** Elément piézoélectrique (1, 1A) comprenant :

le stratifié piézoélectrique (5, 5A) selon l'une quelconque des revendications 1 à 6 ; et
une couche d'électrode supérieure (18) disposée sur le film piézoélectrique (15) du stratifié piézoélectrique (5, 5A).

# FIG. 1

# FIG. 2

# FIG. 3

# FIG. 4

# FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018085478 A
- JP 2007300071 A
- JP 2011103327 A
- JP 2000015809 A

- WO 2020250591 A
- WO 2020250632 A
- JP 2020202327 A